# EUROPEAN PATENT APPLICATION

(11) **EP 4 265 661 A1**
(43) Date of publication of application: **25.10.2023**
(21) Application number: 21906353.4
(22) Date of filing: 02.12.2021
(51) Int. Cl.: C08F 290/06, C08G 77/46, C08F 293/00, C09D 201/00, G03F 7/075, C09D 7/47

(54) **COMPOUND, LEVELING AGENT, COATING COMPOSITION, RESIST COMPOSITION, AND ARTICLE**

(30) Priority: 17.12.2020 JP 2020209102
(71) Applicant: DIC Corporation, Tokyo 174-8520 (JP)
(72) Inventor: NOGUCHI, Yuuki, Ichihara-shi, Chiba 290-8585 (JP); HATASE, Masaki, Ichihara-shi, Chiba 290-8585 (JP); NOGUCHI, Jun, Ichihara-shi, Chiba 290-8585 (JP); SHIMIZU, Ryohei, Ichihara-shi, Chiba 290-8585 (JP); UENO, Junpei, Ichihara-shi, Chiba 290-8585 (JP); SASAMOTO, Shin, Ichihara-shi, Chiba 290-8585 (JP); SUZUKI, Hideya, Ichihara-shi, Chiba 290-8585 (JP)
(74) Representative: TBK
(86) International application number: PCT/JP2021/044182
(87) International publication number: WO 2022/130990

(57) **Abstract**

Provided is a compound functioning as a leveling agent which imparts high smoothness to a coating film without causing a defect in the surface of the coating film. Specifically, the compound has a polymer block of a polymerizable monomer at both ends of a silicone chain.

## Description

### Technical Field

The present invention relates to a compound, a leveling agent, a coating composition, a resist composition, and an article.

### Background Art

A leveling agent is an additive which improves cissing and unevenness of a coating film obtained by coating a coating composition such as a coating material composition, a resist composition, or the like.

Specifically, when a leveling agent is added to a coating composition, the function of decreasing the surface tension of a coating film can be produced due to alignment of the leveling agent on the surface of the coating film, thereby smoothening the resultant coating film. In the coating film having a smoothened surface, the occurrent of cissing and unevenness can be improved.

The leveling agent is used in various applications, for example, a color resist composition used for forming a color filter for a liquid crystal display.

The production of a color filter includes a step of coating a color resist composition on a glass substrate by a coating method such as spin coating, slit coating, or the like, exposing, after drying, the resultant coating film to light by using a mask, and then developing the coating film, thereby forming a colored pattern. In this step, when unevenness occurs in the film thickness due to poor smoothness of the coating film or when coating unevenness or cissing occurs, color unevenness may occur in pixels.

The smoothness of the resultant coating film can be improved by adding the leveling agent to a color resist composition, and thus the surfaces of red (R), green (G), and blue (B) pixels and a black matrix (BM) formed between these pixels can exhibit high smoothness, thereby enabling to produce a color filter having little color unevenness.

A leveling agent composed of a silicone-based polymer is proposed as the leveling agent which causes smoothness of a coating film (Patent Literatures 1 ad 2).

### Citation List

### Patent Literature

PTL 1: Japanese Unexamined Patent Application Publication No. 2018-199765
PTL 2: Japanese Unexamined Patent Application Publication No. 2002-179991

### Summary of Invention

### Technical Problem

The silicone-based polymer of Patent Literatures 1 and 2 is a polymer having a plurality of silicone chains in one polymer and can exhibit a leveling property, but has the problem of failing to sufficiently suppress the occurrence a defect in the surface of a coating film because the density of silicone chains is locally increased.

A problem to be solved by the present invention is to provide a compound functioning as a leveling agent which imparts high smoothness to a coating film without causing a defect in the surface of the coating film.

### Solution to Problem

As a result of earnest investigation, the inventors found that a compound having a polymer block of a polymerizable monomer at both ends of a silicone chain can produce excellent leveling performance without causing a defect in the surface of a coating film, leading to the achievement of the present invention.

That is, the present invention relates to a compound having a polymer block of a polymerizable monomer at both ends of a silicone chain.

### Advantageous Effects of Invention

According to the present invention, there is provided a compound functioning as a leveling agent which imparts high smoothness to a coating film without causing a defect in the surface of the coating film.

### Description of Embodiments

An embodiment of the present invention is described below. The present invention is not limited to the embodiment below and can be carried out with an appropriate change within a range which does not impair the effect of the present invention.

In the present specification, the term "(meth)acrylate" represents either or both of "acrylate" and "methacrylate".

### [Compound]

A compound of the present invention is a compound having a polymer block of a polymerizable monomer at both ends of a silicone chain.

The expression "both ends of a silicone chain" represents both ends of a main chain of a silicone chain (a longest molecular chain among the molecular chains constituting the silicone chain).

The compound of the present invention has a polymer block of a polymerizable monomer at both ends of a silicone chain and thus can exhibit the leveling performance without impairing the compatibility with a base polymer and a solvent of a coating composition. Because the compatibility is not impaired, the occurrence of a defect in the surface of the resultant coating film can be prevented.

The number-average molecular weight of the silicone chain is, for example, within a range of 100 to 50,000, preferably within a range of 500 to 20,000, more preferably within a range of 1,000 to 15,000, and still more preferably within a range of 2,000 to 10,000.

The number-average molecular weight of the silicone chain can be measured by ²⁹Si NMR analysis.

The ratio of the silicone chain is, for example, within a range of 1% to 95% by mass, preferably within a range of 5% to 70% by mass, and more preferably within a range of 10% to 50% by mass.

The ratio of the silicone chain is a value (mass of silicone chain/mass of compound) based on the mass of the compound of the present invention. The ratio of the silicone chain is a value calculated from the raw material charge ratio during production and can be adjusted by the raw material charge ratio between a silicone compound and a polymerizable monomer used for producing the compound of the present invention.

The silicone chain possessed by the compound of the present invention is preferably a silicone chain represented by general formula (1) below. 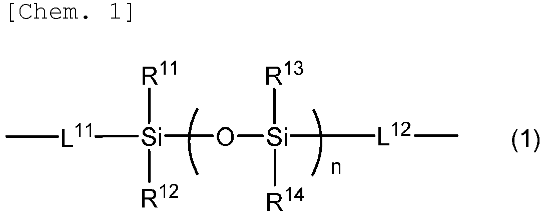 (In the formula (1),
R¹¹, R¹², R¹³, and R¹⁴ are each independently an alkyl group having 1 to 18 carbon atoms or a phenyl group.
L¹¹ and L¹² are each independently a divalent organic group or a single bond.
n is an integer.)

An alkyl group having 1 to 18 carbon atoms as each of R¹¹, R¹², R¹³, and R¹⁴ is preferably an alkyl group having 1 to 6 carbon atoms and more preferably a methyl group.

When n is an integer of 2 or more, a plurality of R¹³ may be the same or different, and a plurality of R¹⁴ may be the same or different.

The number average of n is preferably an integer within a range of 5 to 300, more preferably an integer within a range of 10 to 250, still more preferably an integer within a range of 20 to 200, and most preferably an integer within a range of 40 to 150.

The divalent organic group as each of L¹¹ and L¹² is preferably an alkylene group having 1 to 50 carbon atoms or an alkyleneoxy group having 1 to 50 carbon atoms.

Examples of an alkylene group having 1 to 50 carbon atoms as each of L¹¹ and L¹² include a methylene group, an ethylene group, a n-propylene group, a n-butylene group, a n-pentylene group, a n-hexylene group, a n-heptylene group, a n-octylene group, a n-nonylene group, a n-decylene group, a n-dodecylene group, an isopropylene group, a 2-methylproylene group, a 2-methylhexylene group, a tetramethylethylene group, and the like.

An alkylene group having 1 to 50 carbon atoms as each of L¹¹ and L¹² is preferably an alkylene group having 1 to 15 carbon atoms, more preferably an alkylene group having 1 to 5 carbon atoms, and still more preferably a methylene group, an ethylene group, a n-propylene group, or an isopropylene group.

An alkyleneoxy group having 1 to 50 carbon atoms as each of L¹¹ and L¹² is, for example, a group in which one or more -CH₂- in the alkylene group is substituted by -O-.

An alkyleneoxy group having 1 to 50 carbon atoms as each of L¹¹ and L¹² is preferably an alkyleneoxy group having 1 to 15 carbon atoms, more preferably an alkyleneoxy group having 1 to 8 carbon atoms, and still more preferably a methyleneoxy group, an ethyleneoxy group, a propyleneoxy group, an oxytrimethylene group, a butyleneoxy group, an oxytetramethylene group, a pentyleneoxy group, a heptyleneoxy group, or an octyleneoxy group.

When the divalent organic group as each of L¹¹ and L¹² is an alkylene group having 1 to 50 carbon atoms or an alkyleneoxy group having 1 to 50 carbon atoms, -CH₂- of the divalent organic group may be partially substituted by a carbonyl bond (-C(=O))-), an ester bond (-C(=O)O-), an amide bond (-C(=O)-NH-), or a phenylene group.

When the divalent organic group as each of L¹¹ and L¹² is an alkylene group having 1 to 50 carbon atoms or an alkyleneoxy group having 1 to 50 carbon atoms, a hydroxyl group or the like may be further substituted to a carbon atom.

In the formula (1), a bond possessed by the divalent organic group as L¹¹ and L¹² is a bond bonded to a polymer block of a polymerizable monomer directly or through a linking group.

With respect to the polymer block of the polymerizable monomer possessed by the compound of the present invention, the "polymerizable monomer" represents a compound having a polymerizable unsaturated group, and the "polymer block" represents a segment composed of a repeating structure derived from the polymerizable monomer.

Examples of the polymerizable unsaturated group include a (meth)acryloyl group, a (meth)acryloyloxy group, a (meth)acryloyl amino group, a vinyl ether group, an allyl group, a styryl group, an maleimide group, and the like. Among these, a (meth)acryloyl group and a (meth)acryloyloxy group are preferred because of easy availability of raw materials and good polymerization reactivity.

The polymer block of the polymerizable monomer possessed by the compound of the present invention is preferably a polymer block of a polymerizable monomer (2) which can show compatibility with a base polymer of a coating composition.

The polymerizable monomer (2) is preferably a polymerizable monomer having one or more selected from an alkyl group having 1 to 18 carbon atoms, an aromatic group having 6 to 18 carbon atoms, a group containing a polyoxyalkylene chain, and a group having a polyester chain.

An alkyl group having 1 to 18 carbon atoms possessed by the polymerizable monomer (2) may be any one of a linear alkyl group, a branched alkyl group, and a cyclic alkyl group, and specific examples thereof include a methyl group, an ethyl group, a normal propyl group, an isopropyl group, a n-butyl group, a tert-butyl group, a n-hexyl group, a cyclohexyl group, a n-octyl group, a hexadecyl group, and the like.

The alkyl group having 1 to 18 carbon atoms possessed by the polymerizable monomer (2) is preferably an alkyl group having 1 to 6 carbon atoms.

Examples of an aromatic group having 6 to 18 carbon atoms possessed by the polymerizable monomer (2) include a phenyl group, a naphthyl group, an anthracen-1-yl group, a phenanthren-1-yl group, and the like.

The group containing a (poly)oxyalkylene chain possessed by the polymerizable monomer (2) is a monovalent group containing an oxyalkylene repeating part or a divalent linking group containing an oxyalkylene repeating part.

When the polymerizable unsaturated group possessed by the polymerizable monomer (2) is a (meth)acryloyl group, the polymerizable monomer having the group containing a (poly)oxyalkylene chain is, for example, a compound represented by general formula (2-poa1) or (2-poa2) below. 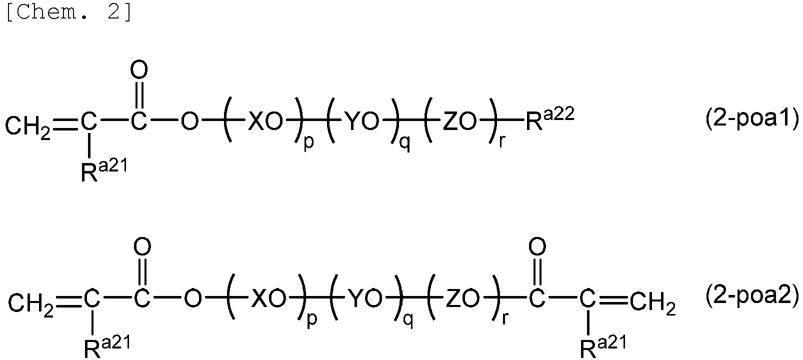 (In the formulae (2-poa1) and (2-poa2),
R^{a21} are each independently a hydrogen atom or a methyl group.
R^{a22} is a hydrogen atom or an alkyl group having 1 to 18 carbon atoms.
P is an integer of 0 or more, q is an integer of 0 or more, r is an integer of 0 or more, and p + q + r is an integer of 1 or more.
X, Y, and Z are each independently an alkylene group having 1 to 6 carbon atoms.

In the formulae (2-poa1) and (2-poa2), a group represented by -(XO)ₚ-(YO)_{q}-(ZO)ᵣ-R^{a22} and a group represented by -(XO)ₚ-(YO)_{q}-(ZO)ᵣ- each correspond to a group containing a (poly)oxyalkylene chain.

In the formulae (2-poa1) and (2-poa2), an alkylene group having 1 to 6 carbon atoms as each of X, Y, and Z is preferably al alkylene group having 2 to 4 carbon atoms.

Examples of the polymerizable monomer (2) having an alkyl group having 1 to 18 carbon atoms and a (meth)acryloyl group as the polymerizable unsaturated group include (meth)acrylic acid alkyl esters having 1 to 18 carbon atoms, such as methyl (meth)acrylate, ethyl (meth)acrylate, n-propyl (meth)acrylate, isopropyl (meth)acrylate, n-butyl (meth)acrylate, s-butyl (meth)acrylate, isobutyl (meth)acrylate, tert-butyl (meth)acrylate, n-pentyl (meth)acrylate, n-hexyl (meth)acrylate, n-heptyl (meth)acrylate, n-octyl (meth)acrylate, 2-ethylhexyl (meth)acrylate, decyl (meth)acrylate, dodecyl (meth)acrylate, stearyl (meth)acrylate, isostearyl (meth)acrylate, and the like; (meth)acrylic acid crosslinked cyclic alkyl esters having 1 to 18 carbon atoms, such as dicyclopentanyloxy ethyl (meth)acrylate, isobornyloxy ethyl (meth)acrylate, isobornyl (meth)acrylate, adamantyl (meth)acrylate, dimethyladamantyl (meth)acrylate, dicyclopentanyl (meth)acrylate, dicylopentenyl (meth)acrylate, and the like; and the like.

Examples of the polymerizable monomer (2) having a phenylalkyl group having 7 to 18 carbon atoms or a phenoxyalkyl group having 7 to 18 carbon atoms and a (meth)acryloyl group as the polymerizable unsaturated group include benzyl (meth)acrylate, phenoxymethyl (meth)acrylate, 2-phenoxyethyl (meth)acrylate, and the like.

Examples of the polymerizable monomer (2) having an alkyl group having 1 to 18 carbon atoms and a vinyl ether group as the polymerizable unsaturated group include alkyl vinyl ethers such as methyl vinyl ether, ethyl vinyl ether, n-propyl vinyl ether, isopropyl vinyl ether, n-butyl vinyl ether, isobutyl vinyl ether, tert-butyl vinyl ether, n-pentyl vinyl ether, n-hexyl vinyl ether, n-octyl vinyl ether, n-dodecyl vinyl ether, 2-ethylhexyl vinyl ether, cyclohexyl vinyl ether, and the like; cycloalkyl vinyl ether; and the like.

Examples of the polymerizable monomer (2) having an aromatic group having 6 to 18 carbon atoms include styrene, α-methylstyrene, p-methylstyrene, p-methoxystyrene, and the like.

Examples of the polymerizable monomer (2) having an alkyl group having 1 to 18 carbon atoms and a (meth)acryloylamino group as the polymerizable unsaturated group include N,N-dimethylacrylamide, N,N-diethylacrylamide, N-isopropylacrylamide, diacetone acrylamide, acryloylmorpholine, and the like.

Examples of the polymerizable monomer (2) having an alkyl group having 1 to 18 carbon atoms and a maleimide group as the polymerizable unsaturated group include methylmaleimide, ethylmaleimide, propylmaleimide, butylmaleimide, hexylmaleimide, octylmaleimide, dodecylmaleimide, stearylmaleimide, cyclohexylmaleimide, and the like.

Examples of the polymerizable monomer (2) having a group containing a polyoxyalkylene chain and a (meth)acryloyl group as the polymerizable unsaturated group include polypropylene glycol mono (meth)acrylate, polyethylene glycol mono(meth)acrylate, polytrimethylene glycol mono(meth)acrylate, polytetramethylene glycol mono(meth)acrylate, poly(ethylene glycol-propylene glycol) mono(meth)acrylate, polyethylene glycol-polypropylene glycol mono(meth)acrylate, poly(ethylene glycol-tetramethylene glycol) mono(meth)acrylate, polyethylene glycol-polytetramethylene glycol mono(meth)acrylate, poly(propylene glycol-tetramethylene glycol) mono(meth)acrylate, polypropylene glycol-polytetramethylene glycol mono(meth)acrylate, poly(propylene glycol-1,2-butylene glycol) mono(meth)acrylate, polypropylene glycol-poly-1,2-butylene glycol mono(meth)acrylate, poly(ethylene glycol-1,2-butylene glycol) mono(meth)acrylate, polyethylene glycol-poly-1,2-butylene glycol mono(meth)acrylate, poly(tetraethylene glycol-1,2-butylene glycol) mono(meth)acrylate, polytetraethylene glycol-poly-1,2-butylene glycol mono(meth)acrylate, poly-1,2-butylene glycol mono(meth)acrylate, poly(ethylene glycol-trimethylene glycol) mono(meth)acrylate, polyethylene glycol-polytrimethylene glycol mono(meth)acrylate, poly(propylene glycol-trimethylene glycol) mono(meth)acrylate, polypropylene glycol-polytrimethylene glycol mono(meth)acrylate, poly(trimethylene glycol-tetramethylene glycol) mono(meth)acrylate, polytrimethylene glycol-polytetramethylene glycol mono(meth)acrylate, poly(1,2-butylene glycol-trimethylene glycol) mono(meth)acrylate, poly-1,2-butylene glycol-polytrimethylene glycol mono(meth)acrylate, 2-hydroxyethyl (meth)acrylate, 2-hydroxypropyl (meth)acrylate, 2-hydroxybutyl (meth)acrylate, 4-hydroxybutyl (meth)acrylate, poly(1,2-butylene glycol-tetramethylene glycol) mono(meth)acrylate, poly-1,2-butylene glycol-polytetramethylene glycol mono(meth)acrylate, and the like.

The "poly(ethylene glycol-propylene glycol)" represents a random copolymer of ethylene glycol and propylene glycol, and the "polyethylene glycol-polypropylene glycol" represents a block copolymer of ethylene glycol and propylene glycol.

The polymerizable monomer (2) is preferably at least one or more selected from the group consisting of a compound represented by general formula (2-1) below, a compound represented by general formula (2-2) below, a compound represented by general formula (2-3) below, and a compound represented by general formula (2-4) below, and more preferably at least one or more selected from this e group consisting of a compound represented by general formula (2-1) below, a compound represented by general formula (2-2) below, and a compound represented by general formula (2-3) below.

When the compound of the present invention is used as a leveling agent, these compounds can impart high compatibility to the compound of the present invention. 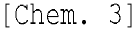 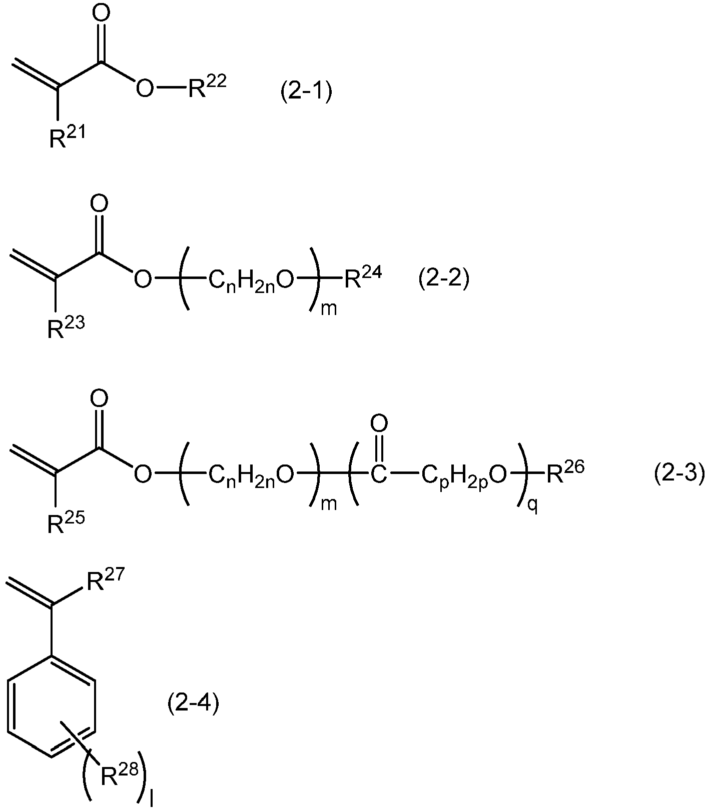 (In the formulae (2-1), (2-2), (2-3), and (2-4),
R²¹ is a hydrogen atom or a methyl group,
R²² is an alkyl group having 1 to 18 carbon atoms,
R²³ is a hydrogen atom or a methyl group,
R²⁴ is a hydrogen atom or an alkyl group having 1 to 18 carbon atoms,
R²⁵ is a hydrogen atom or a methyl group,
R²⁶ is a hydrogen atom or an alkyl group having 1 to 18 carbon atoms,
R²⁷ is a hydrogen atom or a methyl group,
R²⁸ are each independently an alkyl group having 1 to 6 carbon atoms or an alkoxy group having 1 to 6 carbon atoms,
n is an integer within a range of 1 to 4, m is an integer within a range of 1 to 200, p is an integer within a range of 1 to 10, q is an integer within a range of 1 to 100, and l is an integer of 0 to 5.)

The compound represented by the formula (2-3) is, for example, a lactone modified product of the compound represented by the formula (2-2).

The polymerizable monomer (2) can be produced by a known method.

Also, a commercial product may be used as the polymerizable monomer (2). Examples of a commercial product of the polymerizable monomer (2) having a group containing the polyoxyalkylene chain and a (meth)acryloyl group as the polymerizable unsaturated group include those manufactured by Shin-Nakamura Chemical Co., Ltd., such as "NK Ester M-20G", "NK Ester M-40G", "NK Ester RM-90G", "NK Ester M-230G", "NK Ester AM-90G", "NK Ester AMP-10G", "NK Ester AMP-20G", and "NK Ester AMP-60G"; those manufactured by NOF Corporation, such as "Blemmer PE-90", "Blemmer PE-200", "Blemmer PE-350", "Blemmer PME-100", "Blemmer PME-200", "Blemmer PME-400", "Blemmer PME-4000", "Blemmer PP-1000", "Blemmer PP-500", "Blemmer PP-800", "Blemmer 70PEP-350B", "Blemmer 55PET-800", "Blemmer 50POEP-800B", "Blemmer 10PPB-500B", "Blemmer NKH-5050", "Blemmer AP-400", and "Blemmer AE-350"; Placcel F series manufactured by Daicel Corporation; and the like.

With respect to the polymer block of the polymerizable monomer possessed by the compound of the present invention, the polymerizable monomers may be used alone or in combination of two or more as the polymerizable monomer constituting the polymer block.

When the polymer block is a copolymer of two or more polymerizable monomers, the polymerization form of the copolymer is not limited, and may be a random copolymer of two or more polymerizable monomers having different structures or a block copolymer of two or more polymerizable monomers having different structures.

The number-average molecular weight (Mn) of the compound of the present invention is preferably within a range of 1,000 to 200,000, more preferably within a range of 1,500 to 30,000, and still more preferably within a range of 2,000 to 10,000.

The weight-average molecular weight (Mw) of the compound of the present invention is preferably within a range of 1,000 to 500,000, more preferably within a range of 2,000 to 100,000, and still more preferably within a range of 4,000 to 40,000.

The values of the number-average molecular weight (Mn) and the weight-average molecular weight (Mw) of the compound of the present invention are measured by a method described in examples.

### [Method for producing compound]

The compound of the present invention can be produced by polymerizing a reaction raw material containing the compound (1) having the polymerizable unsaturated group at eight end of the silicone chain and the polymerizable monomer (2).

The "reaction raw material" represents a component constituting the compound of the present invention and represents not containing components not constituting the compound of the present invention, for example, a catalyst, a solvent, etc. used for production.

For example, a compound having a polymer block at only one of the ends of a silicone chain is produced by using a compound having a polymerizable unsaturated group at only one of the ends of a silicone chain, but a compound having only silicone chain lacking a polymer block may be produced during production. The compound having only a silicone chain has poor compatibility and thus may cause a defect in the surface of a coating film.

The present invention uses the compound (1) having the polymerizable unsaturated group at both ends of the silicone chain and thus has the very low possibility of producing a compound having only a silicone chain and substantially does not contain a component which causes a defect in the surface of a coating film.

Examples of the polymerizable unsaturated group possessed by the compound (1) include a (meth)acryloyl group, a (meth)acryloyloxy group, a (meth)acryloyl amino group, a vinyl ether group, an allyl group, a styryl group, an maleimide group, and the like. Among these, a (meth)acryloyl group and a (meth)acryloyloxy group are preferred because of easy availability of raw materials and good polymerization reactivity.

The compound (1) having the polymerizable unsaturated group at both ends of the silicone chain is preferably a compound represented by general formula (1-1) below. 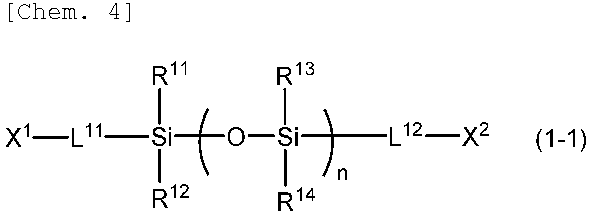 (In the formula (1-1),
R¹¹, R¹², R¹³, and R¹⁴ are each independently an alkyl group having 1 to 18 carbon atoms or a phenyl group.
L¹¹ and L¹² are each independently a divalent organic group or a single bond.
n is an integer.
X¹ an X² are each independently a polymerizable unsaturated group.)

In the formula (1-1), preferred forms of R¹¹, R¹², R¹³, R¹⁴, L¹¹, L¹², and n are the same as the preferred forms of R¹¹, R¹², R¹³, R¹⁴, L¹¹, L¹², and n of the formula (1) .

In the formula (1-1), a polymerizable unsaturated group as each of X¹ an X² is preferably a (meth)acryloyl group, a (meth)acryloyloxy group, or a styryl group because of good polymerizability.

Examples of the compound (1) having the polymerizable unsaturated group at both ends of the silicone chain include following compounds. 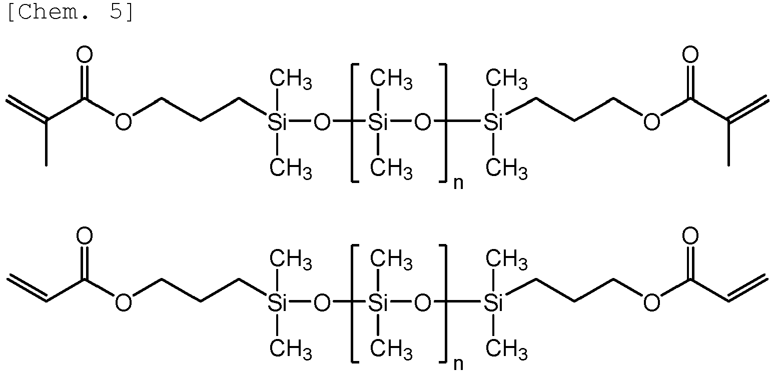 (In the formulae, n is an integer.)

The compound (1) having the polymerizable unsaturated group at both ends of the silicone chain can be produced by a known method (for example, Patent No. 6405647).

The same compounds as described above can be used as the polymerizable monomer (2) as a reaction raw material, and may be used alone or in combination of two or more.

The reaction raw materials used for producing the compound of the present invention are not limited to only the compound (1) having the polymerizable unsaturated group at both ends of the silicone chain and the polymerizable monomer (2), and another monomer other than the compound (1) having the polymerizable unsaturated group at both ends of the silicone chain and the polymerizable monomer (2) may be used within a range not impairing the effect of the present invention.

Examples of the other monomer include hydroxyalkyl (meth)acrylate, para-vinyl benzoic acid, N-phenylmaleimide, and the like. The other monomers may be used alone or in combination of two or more as a reaction raw material.

The charge ratio between the compound (1) having the polymerizable unsaturated group at both ends of the silicone chain and the polymerizable monomer (2) is not particularly limited, but the weight ratio (compound (1)/polymerizable monomer (2)) is, for example, 1/99 to 99/1, preferably 5/95 to 80/20, and more preferably 10/90 to 60/40.

Usable examples of the polymerization method include various polymerization methods such as cast polymerization, bulk polymerization, suspension polymerization, solution polymerization, emulsion polymerization, anionic polymerization, and the like. Among the polymerization methods, bulk polymerization and solution polymerization are preferred because a polymer having little mixing of fine foreign materials can be obtained. In performing the solution polymerization, a solution prepared by dissolving a mixture as the raw materials in an aromatic hydrocarbon solvent, such as toluene, ethylbenzene, or the like, can be used. In polymerization by the bulk polymerization, polymerization can be started, as usually performed, by free radicals, produced by heating, or ionizing radiation irradiation.

Any desired initiator generally used for radical polymerization can be used as an initiator which can be used for the polymerization.

Examples of the initiator include azo compounds such as azobisisobutyronitrile and the like; organic peroxides such as benzoyl peroxide, lauroyl peroxide, tert-butylperoxy-2-ethyl hexanoate, and the like; and the like. When polymerization is performed at a high temperature of 90°C or more, solution polymerization is generally performed. Thus, peroxide and azobis initiators and the like are preferred because of the 10-hour half-life temperature of 80°C or more and being soluble in the organic solvent used. Examples thereof include 1,1-bis(tert-butylperoxy)3,3,5-trimethylcyclohexane, cyclohexane peroxide, 2,5-dimethyl-2,5-di(benzoylperoxy)hexane, 1,1-azobis(1-cyclohexanecarbonitrile), 2-(carbamoylazo)isobutyronitrile, and the like. These initiators are generally used within a range of 0.1% to 20% by mass relative to 100 parts by mass of the polymerization component.

If required, a molecular weight modifier may be used in the polymerization.

Any compound generally used for radical polymerization is used as the molecular weight modifier, and preferred examples thereof include mercaptan compounds such as butyl mercaptan, octyl mercaptan, dodecyl mercaptan, 2-ethylhexyl thioglycolate, and the like. These molecular weight modifiers may be added within a concentration range such that the molecular weight is controlled within the range described above.

The polymerization is performed by using the reaction raw materials containing the compound (1) having the polymerizable unsaturated group at both ends of the silicone chain and the polymerizable monomer (2), there is the possibility of producing as a by-product a polymerized compound of the compound (1). However, the ratio of the number of polymerizable functional groups per molecular weight of the compound (1) is generally relatively lower than the polymerizable monomer (2), and thus the polymerized compound of the compound (1) is not produced so much as to impair the effect of the present invention.

The compound of the present invention can be produced by living polymerization such as living radical polymerization, living anionic polymerization, or the like.

In living radical polymerization, dormant species with the active polymerization ends protected by atoms or atomic groups reversibly produce radicals and react with monomers, and thus growth reaction proceeds. Therefore, even when a first monomer is consumed, the growth ends do not lose activity and react with a second monomer sequentially added, thereby enabling to produce a block polymer. Examples of the living radical polymerization include atom transfer radical polymerization (ATRP), reversible addition-fragmentation radical polymerization (RAFT), nitroxide-mediated radical polymerization (NMP), organotellurium-mediated radical polymerization (TERP), and the like. Which of these methods is used is not particularly limited, but ATRP is preferred in view of ease of control. The ATRP is polymerization using an organic halide or a sulfonyl halide compound, or the like as a polymerization initiator and a metal complex composed of a transition metal compound and a ligand as a catalyst.

Examples of the polymerization initiator which can be used for ATRP include 1-phenylethyl chloride, 1-phenylethyl bromide, chloroform, carbon tetrachloride, 2-chloropropyonitrile, α,α'-dichloroxylene, α,α'-dibromoxylene, hexakis(α-bromomethyl)benzene, alkyl esters having 1 to 6 carbon atoms of 2-halogenated carboxylic acids having 1 to 6 carbon atoms (for example, 2-chloropropionic acid, 2-bromopropionic acid, 2-chloroisobutyric acid, 2-bromoisobutyric acid, and the like), and the like.

More specific examples of alkyl esters (having 1 to 6 carbon atoms) of 2-halogenated carboxylic acids having 1 to 6 carbon atoms include methyl 2-chloropropionate, ethyl 2-chloropropionate, methyl 2-bromopropionate, ethyl 2-bromoisobutyrate, and the like.

The transition metal compound which can be used for ATRP is represented by Mⁿ⁺Xₙ.

The transition metal Mⁿ⁺ of the transition metal compound represented by Mⁿ⁺Xₙ can be selected from the group consisting of Cu⁺, Cu²⁺, Fe²⁺, Fe³⁺, Ru²⁺, Ru³⁺, Cr²⁺, Cr³⁺, Mo⁰, Mo⁺, Mo²⁺, Mo³⁺, W²⁺, W³⁺, Rh³⁺, Rh⁴⁺, Co⁺, Co²⁺, Re²⁺, Re³⁺, Ni⁰, Ni⁺, Mn³⁺, Mn⁴⁺, V²⁺, V³⁺, Zn⁺, Zn²⁺, Au⁺, Au²⁺, Ag⁺, and Ag²⁺.

X of the transition metal compound represented by Mⁿ⁺Xₙ can be selected from the group consisting of halogen atoms, alkoxyl groups having 1 to 6 carbon atoms, (SO₄)_{1/2}, (PO₄)_{1/3}, (HPO₄)_{1/2}, (H₂PO₄), triflate, hexafluorophosphate, methane sulfonate, aryl sulfonate (preferably benzene sulfonate or toluene sulfonate), SeR¹¹, CN, and R¹²COO. Herein, R¹¹ represents an aryl group or a linear or branched alkyl group having 1 to 20 carbon atoms (preferably 1 to 10 carbon atoms), and R¹² represents a hydrogen atom or a linear or branched alkyl group (preferably a methyl group) having 1 to 6 carbon atoms, which may be substituted 1 to 5 rimes by halogen (preferably 1 to 3 times by fluorine or chlorine).

n of the transition metal compound represented by Mⁿ⁺Xₙ represents the formal charge of metal and is an integer of 0 to 7.

Examples of a coordinate compound capable of coordinate bonding to the transition metal of the transition metal compound include a compound having a ligand containing 1 or more nitrogen atoms, oxygen atoms, phosphorus atoms, or sulfur atoms capable of coordinating with the transition metal through σ bonding, a compound having a ligand containing 2 or more carbon atoms capable of coordinating with the transition metal through π bonding, and a compound having a ligand capable of coordinating with the transition metal through µ bonding or η bonding.

The transition metal complex is not particularly limited, but is, for example, preferably a Group 7, 8, 9, 10, or 11 transition metal complex, and more preferably a complex of zero-valent copper, monovalent copper, divalent ruthenium, divalent iron, or divalent nickel.

When the center metal is copper, specific examples of the catalyst which can be used for ATRP include complexes with ligands such as 2,2'-bipyridyl and derivatives thereof, 1,10-phenanthroline and derivatives thereof, polyamines such as tetramethyl ethylenediamine, pentamethyl diethylenetriamine, hexamethyl tris(2-aminoethyl)amine, and the like, and the like. Examples of the divalent ruthenium complex include dichlorotris(triphenylphosphine)ruthenium, dichlorotris(tributylphosphine)ruthenium, dichloro(cyclooctadiene)ruthenium, dichlorobenzene ruthenium, dichloro-p-cymene ruthenium, dichloro(norbornadiene)ruthenium, cis-dichlorobis(2,2'-bipyridine)ruthenium, dichlorotris(1,10-phenanthroline)ruthenium, carbonylchlorohydride tris(triphenylphosphine)ruthenium, and the like. Further, examples of the divalent iron complex include bistriphenylphosphine complex, triazacyclononane complex, and the like.

Living radial polymerization preferably uses a solvent.

Examples of the solvent used in living radical polymerization include ester-based solvents such as ethyl acetate, butyl acetate, propylene glycol monomethyl ether acetate, and the like; ether-bases solvents such as diisopropyl ether, dimethoxyethane, diethylene glycol dimethyl ether, and the like; halogen-bases solvents such as dichloromethane, dichloroethane, and the like; aromatic solvents such as toluene, xylene, and the like; ketone-based solvents such as methyl ethyl ketone, methyl isobutyl ketone, cyclohexanone, and the like; alcohol-based solvents such as methanol, ethanol, isopropanol, and the like; aprotic polar solvents such as dimethylformamide, dimethyl sulfoxide, and the like; and the like.

The above solvents may be used alone or in combination of two or more.

The polymerization temperature of the living radical polymerization is preferably within a range of room temperature to 120°C.

When the compound of the present invention is produced by the living radical polymerization, a metal originated from the transition metal compound used for polymerization may remain in the resultant compound. The metal remaining in the resultant compound may be removed by using active alumina or the like after the completion of polymerization.

### [Coating composition]

The compound of the present invention can be preferably used as a leveling agent of a coating composition. A coating composition of the present invention contains the compound of the present invention. The compound of the present invention can be formed into a fluorine atom-free leveling agent not containing fluorine atom, and thus the leveling agent has a low environmental accumulative property and small environmental load.

The content of the compound of the present invention contained in the coating composition of the present invention varies with the type of the base resin, the coating method, the intended film thickness, etc., but the content relative to 100 parts by mass of the solid content of the coating composition is preferably 0.001 to 10 parts by mass, more preferably 0.01 to 5 parts by mass, and still more preferably 0.02 to 2 parts by mass. When the content of the compound of the present invention is within the range described above, surface tension can be sufficiently decreased, and the intended leveling property can be obtained, thereby enabling to suppress the occurrence of failure such as foaming or the like during coating.

The application of the coating composition of the present invention is not particularly limited, and can be used any application as long as it requires the leveling property. The coating composition of the present invention can be used as, for example, various coating material compositions and photosensitive resin compositions.

When the coating composition is used as a composition for a coating material, examples of the composition for a coating material include coating materials using natural resins, such as a petroleum resin coating material, a shellac coating material, a rosin-based coating material, a cellulose-based coating material, a rubber-based coating material, a lacquer coating material, a cashew resin coating material, an oily vehicle coating material, and the like; coating materials using synthetic resins, such as a phenol resin coating material, an alkyd resin coating material, an unsaturated polyester resin coating material, an amino resin coating material, an epoxy resin coating material, a vinyl resin coating material, an acrylic resin coating material, a polyurethane resin coating material, a silicone resin coating material, a fluorocarbon resin coating material, and the like; and the like.

Smoothness can be imparted to the resultant coating film by adding the compound of the present invention to the composition for a coating material.

If required, the following materials can be properly added to the composition for a coating material: a colorant such as a pigment, a dye, carbon, or the like; an inorganic powder such as silica, titanium oxide, zinc oxide, aluminum oxide, zirconium oxide, calcium oxide, or the like; an organic fine powder such as a higher fatty acid, a polyacrylic resin, polyethylene, or the like; and various additives such as a light-resistance improving agent, a weather-resistance improving agent, a heat-resistance improving agent, an antioxidant, a thickener, an antisettling agent, and the like.

Any method can be used as a coating method for the coating composition of the present invention as long as it is a publicly known/publicly used coating method, and examples thereof include methods such as a slit coater, a slit & spin coater, a spin coater, a roll coater, electrostatic coating, a bar coater, a gravure coater, a die coater, a knife coater, ink jet, dipping coating, spray coating, shower coating, screen printing, gravure printing, offset printing, reverse coating, and the like.

Irradiation with light such as visible light, ultraviolet light, or the like changes the physical properties of the resin of the photosensitive resin composition, such as solubility, viscosity, transparency, refractive index, conductivity, ion permeability, etc.

Among photosensitive resin compositions, a resist composition (a photoresist composition, a color resist composition for a color filter, or the like) is required to have a high degree of leveling property. The resist composition is usually coated so that the thickness is about 1 to 2 µm by spin coating on a silicon wafer or a glass substrate with any one of various metals vapor-deposited thereon. In this case, the occurrence of fluctuation of the coating film thickness or coating unevenness decreases the linearity and reproducibility of a pattern and thus causes the problem of failing to obtain a resist pattern having intended precision. Besides the problem, there are also various problem concerning leveling, such as dropping marks, overall unevenness, the bead phenomenon of thickening of the film at an edge part as compared with a central part.

The coating composition of the present invention can form a uniform coating film (cured film) due to the compound of the present invention which exhibits a high degree of leveling property. Thus, when the coating composition is used as a resist composition, the problems as described above can be solved.

When the coating composition of the present invention is used as a photoresist composition, the photoresist composition contains, other than the compound of the present invention, an alkali soluble resin, a radiation-sensitive material (photosensitive material), a solvent, etc.

The alkali soluble resin contained in the photoresist composition is a resin soluble in an alkali solution which is a developer used for resist patterning.

Examples of the alkali soluble resin include a novolac resin produced by condensing an aromatic hydroxyl compound derivative, such as phenol, cresol, xylenol, resorcinol, phloroglucinol, hydroquinone, or the like, with an aldehyde compound such as formaldehyde, acetaldehyde, benzaldehyde, or the like; a polymer or copolymer of a vinylphenol compound derivative such as o-vinylphenol, m-vinylphenol, p-vinylphenol, α-methylvinylphenol, or the like; a polymer or copolymer of (meth)acrylic acid, such as acrylic acid, methacrylic acid, hydroxyethyl (meth)acrylate, or the like; polyvinyl alcohol; a modified resin having a radiation-sensitive group, such as a quinone diazide group, a naphthoquinone diazide group, an aromatic azide group, an aromatic cinnamoyl group, or the like introduced through some of the hydroxyl groups of any one of these resins; a urethane resin containing an acid group such as a carboxylic acid, sulfonic acid, or the like in its molecule; and the like.

These alkali soluble resins may be used alone or in combination of two or more.

The radiation-sensitive material contained in the photoresist composition is a material which changes the solubility of the alkali soluble resin in a developer by irradiation with energy rays such as ultraviolet light, far-ultraviolet light, excimer laser beams, X-rays, electron beams, ion beams, molecular beams, γ-rays, or the like.

Examples of the radiation-sensitive material include a quinonediazide-based compound, a diazo-based compound, an azide-based compound, an onium salt compound, a halogenated organic compound, a mixture of a halogenated organic compound and an organometal compound, an organic acid ester compound, an organic acid amide compound, an organic imide compound, poly(olefin sulfone) compound, and the like.

Examples of the quinonediazide-based compound include 1,2-benzoquinonediazide-4-sulfonic acid ester, 1,2-naphthoquinonediazide-4-sulfonic acid ester, 1,2-naphthoquinonediazide-5-sulfonic acid ester, 2,1-naphthoquinonediazide-4-sulfonic acid ester, 2,1-naphthoquinonediazide-5-sulfonic acid ester, and sulfonic acid chlorides of quinonediazide derivatives such as 1,2-benzoquinoneazide-4-sulfonic acid chloride, 1,2-naphthoquinonediazide-4-sulfonic acid chloride, 1,2-naphthoquinonediazide-5-sulfonic acid chloride, 2,1-naphthoquinonediazide-4-sulfonic acid chloride, 2,1-naphthoquinonediazide-5-sulfonic acid chloride, and the like.

Examples of the diazo-based compound include a salt of condensate of p-diazodiphenylamine and formaldehyde or acetaldehyde, a hexafluorophosphoric acid salt, a tetrafluoroboric acid salt, a diazo resin inorganic salt which is a reaction product of perchlorate salt or periodate salt and the condensate described above, a diazo resin organic salt which is a reaction product of the condensate and sulfonic acid as described in the specification of USP No. 3,300,309, and the like.

Examples of the azide-based compound include azidechalconic acid, diazidebenzalmethyl cyclohexanones, azide cinnamilydene acetophenones, aromatic azide compounds, aromatic diazide compounds, and the like.

Examples of the halogenated organic compound include a halogen-containing oxadiazole-based compound, a halogen-containing triazine-based compound, a halogen-containing acetophenone-based compound, a halogen-containing benzophenone-based compound, a halogen-containing sulfoxide-based compound, a halogen-containing sulfone-based compound, a halogen-containing thiazole-based compound, a halogen-containing oxazole-based compound, a halogen-containing triazole-based compound, a halogen-containing 2-pyrone-based compound, a halogen-containing aliphatic hydrocarbon-based compound, a halogen-containing aromatic hydrocarbon-based compound, a halogen-containing heterocyclic compound, a sulphenyl halide-based compound, and the like.

Other examples of the halogenated organic compound include compounds used as a halogen-based flame retardant, such as tris(2,3-dibromopropyl) phosphate, tris(2,3-dibromo-3-chloropropyl) phosphate, chlorotetrabromomethane, hexachlorobenzene, hexabromobenzene, hexabromocyclododecane, hexabromobiphenyl, tribromophenyl allyl ether, tetrachlorobisphenol A, tetrabromobisphenol A, bis(bromoethyl ether) tetrabromobisphenol A, bis(chloroethyl ether) tetrachlorobisphenol A, tris(2,3-dibromopropyl) isocyanurate, 2,2-bis(4-hydroxy-3,5-dibromophenyl) propane, 2,2-bis(4-hydroxyethoxy-3,5-dibromophenyl) propane, and the like; compounds used as an organic chloro-based agrichemical, such as dichlorophenyl trichloroethane and the like; and the like.

Examples of the organic acid ester include a carboxylic acid ester, a sulfonic acid ester, and the like. Examples of the organic acid amide include carboxylic acid amide, sulfonic acid amide, and the like. Further, examples of the organic acid imide include carboxylic acid imide, sulfonic acid imide, and the like.

The radiation-sensitive materials may be used alone or in combination of two or more.

The content of the radiation-sensitive material in the photoresist composition is preferably within a range of 10 to 200 parts by mass and more preferably within a range of 50 to 150 parts by mass relative to 100 parts by mass of the alkali-soluble resin.

Examples of the solvent for the photoresist composition include ketones such as acetone, methyl ethyl ketone, cyclohexanone, cyclopentanone, cycloheptanone, 2-heptanone, methyl isobutyl ketone, butyrolactone, and the like; alcohols such as methanol, ethanol, n-propyl alcohol, isopropyl alcohol, n-butyl alcohol, iso-butyl alcohol, tert-butyl alcohol, pentanol, heptanol, octanol, nonanol, decanol, and the like; ethers such as ethylene glycol dimethyl ether, ethylene glycol diethyl ether, dioxane, and the like; alcohol ethers such as ethylene glycol monomethyl ether, ethylene glycol monoethyl ether, ethylene glycol monopropyl ether, propylene glycol monomethyl ether, propylene glycol monoethyl ether, propylene glycol monopropyl ether, and the like; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, butyl lactate, and the like; monocarboxylic acid esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, butyl 2-methoxypropionate, and the like; cellosolve esters such as cellosolve acetate, methyl cellosolve acetate, ethyl cellosolve acetate, propyl cellosolve acetate, butyl cellosolve acetate, and the like; propylene glycols such as propylene glycol, propylene glycol monomethyl ether, propylene glycol monomethyl ether acetate, propylene glycol monoethyl ether acetate, propylene glycol monobutyl ether acetate, and the like; diethylene glycols such as diethylene glycol monomethyl ether, diethylene glycol monoethyl ether, diethylene glycol dimethyl ether, diethylene glycol diethyl ether, diethylene glycol methyl ethyl ether, and the like; halogenated hydrocarbons such as trichloroethylene, flon solvent, HCFC, HFC, and the like; fully fluorinated solvents such as perfluorooctane and the like; aromatics such as toluene, xylene, and the like; polar solvents such as dimethyl acetiamide, dimethyl formamide, N-methyl acetamide, N-methylpyrrolidone, and the like.

These solvents may be used alone or in combination of two or more.

When the coating composition of the present invention is used as the color resist composition, the color resist composition contains, other than the compound of the present invention, an alkali soluble resin, a polymerizable compound, a colorant, etc.

Usable examples of the alkali soluble resin contained in the color resist include the same as those of the alkali soluble resin contained in the photoresist composition described above.

The polymerizable compound contained in the color resist composition is, for example, a compound having a photopolymerizable functional group capable of polymerization or crosslinking reaction by irradiation of active energy rays such as ultraviolet light or the like.

Examples of the polymerizable compound include unsaturated carboxylic acids such as (meth)acrylic acid and the like; an ester of monohydroxy compound and unsaturated carboxylic acid; an ester of an aliphatic polyhydroxy compound and unsaturated carboxylic acid; an ester of an aromatic polyhydroxy compound and unsaturated carboxylic acid; an ester produced by esterification reaction of unsaturated carboxylic acid with polyvalent carboxylic acid and a polyvalent hydroxy compound, such as the aliphatic polyhydroxy compound, the aromatic polyhydroxy compound, or the like; a polymerizable compound having a urethane skeleton produced by reaction of a polyisocyanate compound with a (meth)acryloyl group-containing hydroxy compound; a polymerizable compound having an acid group; and the like.

The polymerizable compounds may be uses alone or in combination of two or more.

Examples of the ester of aliphatic polyhydroxy compound and unsaturated carboxylic acid include (meth)acrylate esters such as ethylene glycol di(meth)acrylate, triethylene glycol di(meth)acrylate, trimethylolpropane tri(meth)acrylate, trimethylolethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, glycerol (meth)acrylate, and the like.

Other examples include itaconate esters produced by changing the (meth)acrylic acid parts of these acrylates by itaconic acid, crotonate esters produced by changing the (meth)acrylic acid parts of these acrylates by crotonic acid, maleate esters produced by changing the (meth)acrylic acid parts of these acrylates by maleic acid, and the like.

Examples of the ester of aromatic polyhydroxy compound and unsaturated carboxylic acid include hydroquinone di(meth)acrylate, resorcin di(meth)acrylate, pyrogallol tri(meth)acrylate, and the like.

The ester produced by esterification reaction of unsaturated carboxylic acid with polyvalent carboxylic acid and polyvalent hydroxy compound may be a single substance or a mixture. Examples of such an ester include an ester obtained from (meth)acrylic acid, phthalic acid, and ethylene glycol, an ester obtained from (meth)acrylic acid, maleic acid, and diethylene glycol, an ester obtained from (meth)acrylic acid, terephthalic acid, and pentaerythritol, an ester produced by (meth)acrylic acid, adipic acid, butanediol, and glycerin, and the like.

The polymerizable compound having a urethane skeleton produced by reaction of polyisocyanate compound with (meth)acryloyl group-containing hydroxy compound is, for example, a rection product of aliphatic diisocyanate, such as hexamethylene diisocyanate, trimethyl hexamethylene diisocyanate, or the like, alicyclic diisocyanate, such as cyclohexane diisocyanate, isophorone diisocyanate, or the like, and aromatic diisocyanate, such as tolylene diisocyanate, diphenylmethane diisocyanate, or the like, with a (meth)acryloyl group-containing hydroxy compound, such as 2-hydroxyethyl (meth)acrylate, 3-hydroxy[1,1,1-tri(meth)acryloyloxymethyl]propane, or the like.

The polymerizable compound having an acid group is, for example, an ester of aliphatic polyhydroxy compound and unsaturated carboxylic acid, and is preferably a polyfunctional polymerizable compound having an acid group imparted by reaction of an unreacted hydroxyl group of aliphatic polyhydroxy compound with non-aromatic carboxylic anhydride. The aliphatic polyhydroxy compound used for preparing the polyfunctional polymerizable compound is preferably pentaerythritol or dipentaerythritol.

Because of good development properties, curability, etc., the acid value of the polyfunctional polymerizable compound is preferably within a range of 0.1 to 40 and more preferably within a range of 5 to 30. When two or more polyfunctional polymerizable compounds having an acid group are used in combination, and when a polyfunctional polymerizable compound having an acid group and a polyfunctional polymerizable compound not having an acid group are used in combination, the acid value of a mixture of polymerizable compounds is preferably adjusted to be in the range described above.

Specific examples of the polymerizable compound having an acid group include dipentaerythritol hexaacrylate, and a mixture of dipentaerythritol pentaacrylate and succinate ester of dipentaerythritol pentaacrylate as main components. The mixture is commercially available as Aronix TO-1382 (manufactured by Toa Gosei Co., ltd.).

Other examples of the polymerizable compound include (meth)acrylamide such as ethylene bis(meth)acrylamide and the like, ally esters such as diallyl phthalate and the like; compounds having a vinyl group, such as divinyl phthalate and the like; and the like.

In the color resist composition, the content of the polymerizable compound in the whole solid content of the color resist composition is preferably within a range of 5% to 80% by mass, more preferably within a range of 10% to 70% by mass, and still more preferably within a range of 20% to 50% by mass.

The colorant of the color resist composition is not particularly limited as long as coloring is possible, and may be, for example, either a pigment or a dye.

Either an organic pigment or an inorganic pigment can be used as the pigment. Usable examples of the organic pigment include various color pigments such as a red pigment, a green pigment, a blue pigment, a yellow pigment, a violet pigment, an orange pigment, a brown pigment, and the like. Examples of a chemical structure of the organic pigment include azo-based, phthalocyanine-based, quinacridone-based, benzimidazolone-based, isoindolinone-based, dioxazine-based, indanthrene-based, and perylene-based chemical structures, and the like. Also, examples of the inorganic pigment include barium sulfate, lead sulfate, titanium oxide, yellow lead, bengala, chromium oxide, and the like.

In addition, "C. I." below represents Color Index.

Examples of the red pigment include C. I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276, and the like. Among these, C. I. Pigment Red 48:1, 122, 168, 177, 202, 206, 207, 209, 224, 242, or 254 is preferred, and C. I. Pigment Red 177, 209, 224, or 254 is more preferred.

Examples of the green pigment include C. I. Pigment Green 1, 2, 4, 7, 8, 10, 13, 14, 15, 17, 18, 19, 26, 36, 45, 48, 5 0, 51, 54, 55, and 58, and the like. Among these, C. I. Pigment Green 36 or 58 is preferred.

Examples of the blue pigment include C. I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, and 79, and the like. Among these, C. I. Pigment Blue 15, 15:1, 15:2, 15:3, 15:4, or 15:6 is preferred, and C. I. Pigment Blue 15:6 is more preferred.

Examples of the yellow pigment include C. I. Pigment Yellow 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75,81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, and 208, and the like. Among these, C. I. Pigment Yellow 83, 117, 129, 138, 139, 150, 154, 155, 180, or 185 is preferred, and C. I. Pigment Yellow 83, 138, 139, 150, or 180 is more preferred.

Examples of the violet pigment include C. I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49, and 50, and the like. Among these, C. I. Pigment Violet 19 or 23 is preferred, and C. I. Pigment Violet 23 is more preferred.

Examples of the orange pigment include C. I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79, and the like. Among these, C. I. Pigment Orange 38 or 71 is preferred.

The three-primary color pixels of a color filter used in a liquid crystal display device and an organic EL display device are red (R), green (G), and blue (B), and thus the red pigment, the green pigment, and the blue pigment may be used as main components, and organic pigments of yellow, violet, and orange colors, and the like may be used for color adjustment for the purpose of improving color reproducibility.

In order to enhance the luminance of a color liquid crystal display device and an organic EL display device, the average particle diameter of the organic pigment is preferably 1 µm or less, more preferably 0.5 µm or less, and still more preferably 0.3 µm or less. The organic pigment is preferably used after being dispersed so as to obtain the average particle diameter described above.

The average primary particle diameter of the organic pigment is preferably 100 nm or less, more preferably 50 nm or less, still more preferably 40 nm or less, and particularly preferably within a range of 10 to 30 nm.

The average particle diameter of the organic pigment is measured by a dynamic light-scattering type particle size distribution meter, and can be measured by, for example, Nanotrac particle size distribution measuring apparatus "UPA-EX150" or "UPA-EX250" manufactured by Nikkiso Co., Ltd., or the like.

When the color resist composition is used for forming a black matrix (BM), the colorant is not particularly limited as long as it is black, and examples thereof include carbon black, lamp black, acetylene black, bone black, thermal black, channel black, furnace black, graphite, iron black, titanium black, and the like. Among these, carbon black and titanium black are preferred in view of light-shielding rate and image characteristics.

In addition, a mixed black color may be formed by mixing a combination of two or more organic pigments.

Examples of commercial products of the carbon black include those manufactured by Mitsubishi Chemical Corporation, such as MA7, MA8, MA11, MA100, MA100R, MA220, MA230, MA600, #5, #10, #20, #25, #30, #32, #33, #40, #44, #45, #47, #50, #52, #55, #650, #750, #850, #950, #960, #970, #980, #990, #1000, #2200, #2300, #2350, #2400, #2600, #3050, #3150, #3250, #3600, #3750, #3950, #4000, #4010, OIL7B, OIL9B, OIL11B, OIL30B, OIL31B,and the like; those manufactured by Evonik Degussa Japan Co., Ltd., such as Printex 3, Printex 3OP, Printex 30, Printex 30OP, Printex 40, Printex 45, Printex 55, Printex 60, Printex 75, Printex 80, Printex 85, Printex 90, Printex A, Printex L, Printex G, Printex P, Printex U, Printex V, Printex G, Special Black 550, Special Black 350, Special Black 250, Special Black 100, Special Black 6, Special Black 5, Special Black 4, Color Black FW1, Color Black FW2, Color Black FW2V, Color Black FW18, Color Black FW18, Color Black FW200, Color Black S160, Color Black S170, and the like; those manufactured by Cabot Japan K. K., such as Monarch 120, Monarch 280, Monarch 460, Monarch 800, Monarch 880, Monarch 900, Monarch 1000, Monarch 1100, Monarch 1300, Monarch 1400, Monarch 4630, REGAL 99, REGAL 99R, REGAL 415, REGAL 415R, REGAL 250, REGAL 250R, REGAL 330, REGAL 400R, REGAL 55R0, REGAL 660R, BLACK PEARLS 480, PEARLS 130, VULCAN XC72R, ELFTEX-8, and the like; and those manufactured by Colombian Carbon Co., Ltd., such as RAVEN 11, RAVEN 14, RAVEN 15, RAVEN 16, RAVEN 22, RAVEN 30, RAVEN 35, RAVEN 40, RAVEN 410, RAVEN 420, RAVEN 450, RAVEN 500, RAVEN 780, RAVEN 850, RAVEN 890H, RAVEN 1000, RAVEN 1020, RAVEN 1040, RAVEN 1060U, RAVEN 1080U, RAVEN 1170, RAVEN 1190U, RAVEN 1250, RAVEN 1500, RAVEN 2000, RAVEN 2500U, RAVEN 3500, RAVEN 5000, RAVEN 5250, RAVEN 5750, RAVEN 7000, and the like.

Among the carbon black products described above, carbon black coated with a resin is preferred because it has a high optical density and high surface resistivity required for a black matrix of a color filter.

Examples of a commercial product of the titanium black include titanium black 10S, 12S, 13R, 13M, 13M-C, and the like which are manufactured by Mitsubishi Materials Corporation.

A mixed black color formed by mixing two or more organic pigments may be used as a colorant used for forming a black matrix (BM), and a black pigment prepared by mixing pigments of the three colors, red, green, and blue, is given.

Examples of a coloring material which can be used and mixed for preparing the black pigment include Victoria Pure Blue (C. I. 42595), Auramine O (C. I. 41000), Cationic Brilliant Flavine (Basic 13), Rhodamine 6GCP (C. I. 45160), Rhodamine B (C. I. 45170), Safranin OK70:100 (C. I. 50240), Erioglaucine X(C. I. 42080), No.120/ Lionol Yellow (C. I. 21090), Lionol Yellow GRO (C. I. 21090), Symuler Fast Yellow 8GF (C. I. 21105), Benzidine Yellow 4T-564D (C. I. 21095), Symuler Fast Red 4015 (C. I. 12355), Lionol Red 7B4401 (C. I. 15850), Fastogen Blue TGR-L (C. I. 74160), Lionol Blue SM (C. I. 26150), Lionol Blue ES (C. I. Pigment Blue 15:6), Lionogen Red GD (C. I. Pigment Red 168), Lionol Green 2YS (C. I. Pigment Green 36), and the like.

Examples of another coloring material which can be used and mixed for preparing the black pigment include C. I. Yellow Pigment 20, 24, 86, 93, 109, 110, 117, 125, 137, 138, 147, 148, 153, 154, and 166, C. I. Orange Pigment 36, 43, 51, 55, 59, and 61, C. I. Red Pigment 9, 97, 122, 123, 149, 168, 177, 180, 192, 215, 216, 217, 220, 223, 224, 226, 227, 228, and 240, C. I. Violet Pigment 19, 23, 29, 30, 37, 40, and 50, C. I. Blue Pigment 15, 15:1, 15:4, 22, 60, and 64, C. I. Green Pigment 7, C. I. Brown Pigment 23, 25, and 26, and the like.

When carbon black is used as the back pigment, the average primary particle diameter of carbon black is preferably within a range of 0.01 to 0.08 µm and, because of good development properties, it is more preferably within a range of 0.02 to 0.05 pm.

Unlike the organic pigment etc., carbon black is present in a state called "structure" in which primary particles are fused with each other, and, also, fine holes may be formed in particle surfaces by post treatment. Therefore, in general, besides the average particle diameter of primary particles, which is determined by the same method as for the organic pigments, the DBP adsorption amount (JIS K6221) and specific surface area by BET method (JIS K6217) are preferably measured and used as indexes of the structure and the amount of fine holes for indicating the particle shape of carbon black.

The dibutyl phthalic acid (abbreviated as "DBP" hereinafter) adsorption amount of carbon black is preferably within a range of 40 to 100 cm³/100 g, and because of good dispersibility and development properties, it is more preferably within a range of 50 to 80 cm³/100 g. The BET method specific surface area of carbon black is preferably within a range of 50 to 120 m²/g, and because of good dispersion stability, it is more preferably within a range of 60 to 95 m²/g.

Examples of the dye used as a colorant in the color resist composition include an azo-based dye, an anthraquinone-based, a phthalocyanine-based dye, a quinoneimine-based dye, a quinoline-based dye, a nitro-based dye, a carbonyl-based dye, a methine-based dye, and the like.

Examples of the azo-based dye include C. I. Acid Yellow 11, C. I. Acid Orange 7, C. I. Acid Red 37, C. I. Acid Red 180, C. I. Acid Blue 29, C. I. Direct Red 28, C. I. Direct Red 83, C. I. Direct Yellow 12, C. I. Direct Orange 26, C. I. Direct Green 28, C. I. Direct Green 59, C. I. Reactive Yellow 2, C. I. Reactive Red 17, C. I. Reactive Red 120, C. I. reactive Black 5, C. I. Disperse Orange 5, C. I. Disperse Red 58, C. I. Disperse Blue 165, C. I. Basic Blue 41, C. I. Basic Red 18, C. I. Mordant Red 7, C. I. Mordant Yellow 5, C. I. Mordant Black 7, and the like.

Examples of the anthraquinone-based dye include C. I. Bat Blue 4, C. I. Acid Blue 40, C. I. Acid Green 25, C. I. Reactive Blue 19, C. I. Reactive Blue 49, C. I. Disperse Red 60, C. I. Disperse Blue 56, C. I. Disperse Blue 60, and the like.

Examples of the phthalocyanine-based dye include C. I. Bat Blue 5 and the like, examples of the quinoneimine-based dye include C. I. Basic Blue 3, C. I. Basic Blue 9, and the like, examples of the quinoline-based dye include C. I. Solvent Yellow 33, C. I. Acid Yellow 3, C. I. Disperse Yellow 64, and the like, and examples of the nitro-based dye include C. I. Acid Yellow 1, C. I. Acid Orange 3, C. I. Disperse Yellow 42, and the like.

In view of the excellent light resistance, weather resistance, and fastness of the resultant coating film, a pigment is preferably used as the colorant of the color resist composition, but if required, a dye may be used in combination with the pigment in order to adjust the hue.

In the color resist composition, the content of the colorant in the total solid content of the color resist composition is preferably 1% by mass or more, more preferably within a range of 5% to 80% by mass, and still more preferably within a range of 5% to 70% by mass.

When the color resist composition is used for forming pixels of each of red (R), green (G), and blue (B) of a color filter, the content of the colorant in the color resist composition is preferably within a range of 5% to 60% by mass and more preferably within a range of 10% to 50% in the total solid content of the color resist composition.

When the color resist composition is used for forming a black matrix of a color filter, the content of the colorant in the color resist composition is preferably within a range of 20% to 80% by mass and more preferably within a range of 30% to 70% by mass in the total solid content of the color resist composition.

When the colorant in the color resist composition is the pigment, a pigment dispersion liquid prepared by dispersing the pigment in an organic solvent using a dispersant is preferably used.

Examples of the dispersant include a surfactant; a pigment intermediate or derivative; a dye intermediate or derivative; resin-type dispersants such as a polyamide-based resin, a polyurethane-based resin, a polyester-based resin, an acrylic resin, and the like; and the like. Among these, a nitrogen atom-containing graft copolymer, a nitrogen atom-containing acrylic block copolymer, a urethane resin dispersant, and the like are preferred. These dispersants have nitrogen atoms having affinity for the pigment surfaces, and thus portions other than the nitrogen atoms increase the affinity for the medium, thereby improving dispersion stability.

These dispersants may be used alone or in combination of two or more.

Examples of a commercial product of the dispersant include "Efka" series ("Efka 46" and the like) manufactured by BASF Corporation; "Disperbyk" series and "BYK" series ("BYK-160", "BYK-161", "BYK-2001", and the like) manufactured by BYK Chemie Japan K. K.; "Solsperse" series manufactured by Lubrizol Corporation; "KP" series manufactured by Shin-Etsu Chemical Co., Ltd.; "Polyflow" series manufactured by Kyoeisha Chemical Co., Ltd.; "Disparlon" series manufactured by Kusumoto Chemicals, Ltd.; "Ajisper" series ("Ajisper PB-814" and the like) manufactured by Ajinomoto Fine-Techno Co., Inc.; and the like.

Examples of the organic solvent used for preparing the pigment dispersion liquid include acetate ester-based solvents such as propylene glycol monomethyl ether acetate, propylene glycol monoethyl ether acetate, and the like; propionate-based solvents such as ethoxypropionate and the like; aromatic solvents such as toluene, xylene, methoxybenzene, and the like; ether-based solvents such as butyl cellosolve, propylene glycol monomethyl ether, diethylene glycol ethyl ether, diethylene glycol dimethyl ether, and the like; ketone-based solvents such as methyl ethyl ketone, methyl isobutyl ketone, cyclohexanone, and the like; aliphatic hydrocarbon-based solvents such as hexane and the like; nitrogen compound-based solvents such as N,N-dimethylformamide, γ-butyrolactam, N-methyl-2-pyrrodidone, and the like; lactone-based solvents such as γ-butyrolactone and the like; carbamate esters; and the like.

These solvents may be used alone or in combination or two or more.

Examples of a method for preparing the pigment dispersion liquid include a method including a step of kneading and dispersing a colorant, and a finely dispersing step, a method including only a finely dispersing step, and the like. In the kneading-dispersing step, the colorant, a portion of the alkali-soluble resin, and, if required, the dispersant are kneaded and dispersed. The colorant can be dispersed by dispersion using a kneader while applying strong shear force.

Examples of a machine used for kneading include a two-roll mill, a three-roll mill, a ball mill, a tron mill, disper, a kneader, a co-kneader, a homogenizer, a blender, a single-screw or twin-screw extruder, and the like.

The particle size of the colorant is preferably micronized by a salt milling method or the like before the kneading described above.

In the finely dispersing step, a mixture prepared by adding a solvent to a composition containing the colorant produced in the kneading-dispersing step, or a mixture prepared by mixing the colorant, the alkali-soluble resin, the solvent, and, if required, the dispersant is mixed and dispersed by using a disperser together with glass, zirconia, or ceramic fine particles as media for dispersion. Thus, the colorant particles can be dispersed to a fine state close to the primary particles.

From the viewpoint of improving the transmittance, contrast, etc. of a color filter, the average particle diameter of colorant primary particles is preferably 10 to 100 nm and more preferably 10 to 60 nm. In addition, the average particle diameter of the colorant is measured by a dynamic light-scattering type particle size distribution meter, and can be measured by, for example, Nanotrac particle size distribution measuring apparatus "UPA-EX150" or "UPA-EX250" manufactured by Nikkiso Co., Ltd., or the like.

The composition for a coating material, the photoresist composition, and the color resist composition are described above as examples of the coating composition, but the coating composition is not limited to these.

Specific examples of application of the coating composition of the present invention include an anti-glare (AG) hard coating material, a low reflection (LR) coating material, a low-refractive-index layer coating material, a high-refractive-index layer coating material, a clear hard coating material, a polymerizable liquid crystal coating material, which are coating materials for screens of various displays such as a liquid crystal display (abbreviated as "LCD" hereinafter), a plasma display (abbreviated as "PDP" hereinafter), an organic EL display (abbreviated as "OLED" hereinafter), a quantum display (abbreviated as "QDD" hereinafter), and the like; a color resist, an ink jet ink, a printing ink, or a coating material for forming pixels of RGB or the like in a color filter (abbreviated as "CF" hereinafter) of LCD or the like; a black resist, an ink jet ink, a printing ink, or a coating material for forming a black matrix, a black column spacer, and a black photo spacer of CF of LCD or the like; a coating material for a transparent protective film used for protecting the CF surface of CF of LCD or the like; a liquid crystal material, a column spacer, and a resin composition for a photo spacer of LCD; a resin composition for pixel partitions, a positive photoresist for forming an electrode, a protective film, an insulting film, a plastic casing, a coating material for plastic casing, and a bezel ink of LCD, PDP, OLED, QDD, and the like; a prism sheet and a light diffusion film as back light members of LCD; a coating material for an organic insulating film of a liquid crystal TFT array of LCD; a coating material for protecting the surface of an internal polarizing plate of LCD; a fluorescent substance of PDP; an organic EL material and a sealing material (a protective film and a gas barrier) of OLED; a quantum dot ink, a sealing material, and a protective film of QDD; a high-refractive-index lens, a low-refractive-index sealing, and LED pixels of a micro (mini) LED display; a positive type photoresist, a chemical amplification type photoresist, an anti-reflection film, a multilayer material (SOC and SOG), a lower layer film, a buffer coat, a developer, a rinse liquid, a pattern fall prevention agent, a polymer residue remover, a chemical liquid such as a cleaning agent and the like, and a nano-imprint release agent, which are used for producing a semiconductor; resin compositions (resin compositions of an epoxy resin, a phenol resin, a polyphenylene ether resin, a liquid crystal polymer, a polyimide resin, a bismaleimide resin, a bisallynadic imide resin, a benzoxazine resin, and the like), a copper clad laminate, a resin coated copper foil, a build-up film, a passivation film, an interlayer insulating film, a flexible copper clad laminate, and a dry film resist for a semiconductor post-process or a printed wiring board; a color resist for an image sensor; a repellent agent for a solder flux; a dispersant, a coating material, and a green sheet for a multi-layer ceramic capacitor; a cathode material, an anode material, a separator, and an electrolytic solution for a lithium ion battery; an exterior coating material, rubber, an elastomer, glass, a vapor deposition material anchor coat, a head lamp lens, a solid lubricating coating material, a heat radiation board, an interior coating material, a coating material for repairing for automobile cars; wallpaper, a floor material, a kitchen member, a bath room/toilet member for housing equipment; an ink jet ink, an ink for offset printing, an ink for gravure printing, an ink for screen printing, a photoresist for a printing plate making process, a photosensitive material for a lithographic printing plate (PS plate), a package adhesive, and a ballpoint pen ink for printed matters; a primer for plastic film easy adhesion; a water repellant for fibers; an anti-diffusion agent for grease; a cleaning liquid for cleaning the surfaces of various products or parts; a hard coat material for optical recording media such as CD, DVD, a blue ray disk, and the like; a coating material or hard coat material for a casing or screen of a smartphone or a cellular phone; a hard coat material for a transfer film for insert mold (IMD and IMF); a release film; a coating material or coat material for various plastic molded articles such as a casing of home appliance and the like; a printing ink or coating material for various building materials such as a decorative sheet and the like; a coating material for a home window glass; a wood coating material for furniture and the like; a coating material for artificial/synthetic leather; a coat material for rubber rollers of OA apparatuses such as a copying machine, a printer, and the like; a glass coat material for reading parts of OA apparatuses such as a copying machine, a scanner, and the like; a camera, a video camera, glasses, an optical lens such as a contact lens or the like, or a coating material therefor; a coating material for a windshield and glass of a watch such as a wristwatch or the like; a coating material for windows of various vehicles such as an automobile car, railroad vehicle, and the like; a coating material for an anti-reflection film of a cover glass or film for a solar cell; a coating material or coat material for a FRP bathtub; PCM for a metal-made building material or housing electric appliance; a single-layer or multi-layer coating composition for a photo-fabrication process or the like; and the like.

The compound of the present invention has the excellent surface tension decreasing ability, and thus not only the leveling property but also various functions such as wettability, permeability, washability, water repellency, oil repellency, an anti-fouling property, lubricity, an anti-blocking property, a releasability can be expected. Also, when the compound of the present invention is mixed with a coating material or coating agent containing fine particles, the dispersibility of the fine particles is improved, and not only the leveling property but also the function as a dispersant for the fine particles can be expected. In addition, when the compound of the present invention is added to an adhesive composition used for an adhesive tape or the like, besides the coating composition, not only the leveling property but also the various functions of decreasing peel force, suppressing a variation in peel force, and suppressing peel electrostatic charge can also be expected.

### EXAMPLES

The present invention is specifically described by examples and comparative examples below.

The present invention is not limited to these examples. In addition, in the description and table below, "parts" and "%" are on mass basis unless otherwise specified and represent a solid content or effective component.

In the examples and comparative examples, the weight-average molecular weight (Mw) and number-average molecular weight (Mn) are values in terms of polystyrene based on gel permeation chromatography (GPC) measurement.

The conditions for GPC measurement are as follows.

### [Conditions for GPC measurement]

Measurement apparatus: high-speed GPC apparatus "HLC-8320GPC" manufactured by Tosoh Corporation
Column: "TSK GUARDCOLUMN SuperHZ-L" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation
Detector: RI (differential refractometer)
Data processing: "EcoSEC Data Analysis version 1.07" manufactured by Tosoh Corporation
Column temperature: 40°C
Developing solvent: tetrahydrofuran
Flow rate: 0.35 mL/min
Measurement sample: The measurement sample was prepared by dissolving 7.5 mg of a sample in 10 mL of tetrahydrofuran and filtering the resultant solution with a micro-filter.
Sample injection amount: 20 µl
Standard sample: The monodisperse polystyrene below having the known molecular weight was used according to the measurement manual of "HLC-8320GPC".

### (Monodisperse polystyrene)

"A-300" manufactured by Tosoh Corporation
"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
"F-288" manufactured by Tosoh Corporation

### (EXAMPLE 1: synthesis of compound having polymer block of polymerizable monomer at both ends of silicone chain)

A mixed solution A was prepared by mixing 102.6 g of polypropylene glycol-polybutylene glycol monomethacrylate (number-average repeat number of polypropylene glycol: 1, number-average repeat number of polybutylene glycol: 6), 152.6 g of butyl acetate as a solvent, and 13.5 g of tert-butylperoxy-2-ethyl hexanoate as an initiator.

A mixed solution B was prepared by mixing 47.4 g of a dimethacrylate compound having a polysiloxane bond represented by formula (A1-1) below and 47.4 g of butyl acetate as a solvent. 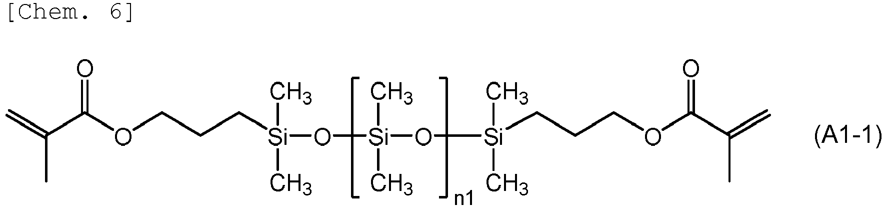 (In the formula (A1-1), the number average of n1 is 64.)

In a glass flask provided with a stirrer, a thermometer, a condenser, a dropping device, 150.0 g of butyl acetate as a solvent was charged and heated to 95°C under stirring in a nitrogen stream.

The mixed solution A was dropped in the glass flask at 95°C over 140 minutes. Five minutes after the start of dropping of the mixed solution A, the mixed solution B was dropped at 95°C over 120 minutes. After the completion of dropping, the resultant mixture was stirred at 95°C for 10 hours. After the completion of reaction, the solvent was distilled off to obtain a compound (1) having a polymer block of a polymerizable monomer at both ends of a silicone chain.

As a result of GPC measurement of the molecular weight of the resultant compound (1), the weight-average molecular weight (Mw) was 12,100, and the number-average molecular weight (Mn) was 2,650.

In addition, the silicone chain ratio in the compound (1) determined from the raw material charge ratio was 30% by mass.

### (EXAMPLE 2: synthesis of compound having polymer block of polymerizable monomer at both ends of silicone chain)

A compound (2) was produced by the same synthesis method as in Example 1 except that 120.0 g of polypropylene glycol-polybutylene glycol monomethacrylate and 30.0 g of a compound represented by the formula (A1-1) were used, and 9.0 g of tert-butylperoxy-2-ethyl hexanoate was used as an initiator.

As a result of GPC measurement of the molecular weight of the resultant compound (2), the weight-average molecular weight (Mw) was 10,400, and the number-average molecular weight (Mn) was 2,540.

In addition, the silicone chain ratio in the compound (2) determined from the raw material charge ratio was 19% by mass.

### (EXAMPLE 3: synthesis of compound having polymer block of polymerizable monomer at both ends of silicone chain)

A compound (3) was produced by the same synthesis method as in Example 1 except that 102.6 g of polypropylene glycol-polybutylene glycol monomethacrylate and 47.4 g of a compound represented by the formula (A1-1) were used, and 22.5 g of tert-butylperoxy-2-ethyl hexanoate was used as an initiator.

As a result of GPC measurement of the molecular weight of the resultant compound (3), the weight-average molecular weight (Mw) was 7,000, and the number-average molecular weight (Mn) was 2,180.

In addition, the silicone chain ratio in the compound (3) determined from the raw material charge ratio was 30% by mass.

### (EXAMPLE 4: synthesis of compound having polymer block of polymerizable monomer at both ends of silicone chain)

A compound (4) was produced by the same synthesis method as in Example 1 except that 102.6 g of polypropylene glycol-polybutylene glycol monomethacrylate and 47.4 g of a compound represented by the formula (A1-1) were used, and 9.0 g of tert-butylperoxy-2-ethyl hexanoate was used as an initiator.

As a result of GPC measurement of the molecular weight of the resultant compound (4), the weight-average molecular weight (Mw) was 43,500, and the number-average molecular weight (Mn) was 3,270.

In addition, the silicone chain ratio in the compound (4) determined from the raw material charge ratio was 30% by mass.

### (COMPARATIVE EXAMPLE 1: synthesis of polymer having silicone chain at side chain)

A mixed solution A' was prepared by mixing 136.8 g of polypropylene glycol-polybutylene glycol monomethacrylate (number-average repeat number of polypropylene glycol: 1, number-average repeat number of polybutylene glycol: 6), 202. 8 g of butyl acetate as a solvent, and 6.0 g of tert-butylperoxy-2-ethyl hexanoate as an initiator.

A mixed solution B' was prepared by mixing 63.2 g of a methacrylate compound having a polysiloxane bond represented by formula (A1-2) below and 63.2 g of butyl acetate as a solvent.

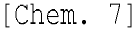

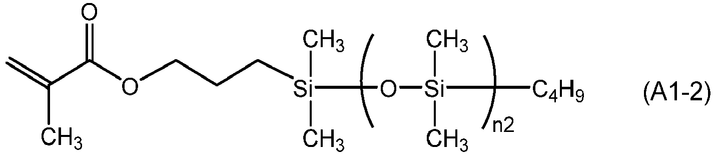

### (In the formula (A1-2), the number average of n2 is 65.)

In a glass flask provided with a stirrer, a thermometer, a condenser, a dropping device, 200.0 g of butyl acetate as a solvent was charged and heated to 90°C under stirring in a nitrogen stream.

The mixed solution A' was dropped in the glass flask at 90°C over 135 minutes. Five minutes after the start of dropping of the mixed solution A', the mixed solution B' was dropped at 90°C over 120 minutes. After the completion of dropping, the resultant mixture was attired at 90°C for 10 hours. After the completion of reaction, the solvent was distilled off to obtain a polymer compound (1') having a silicone chain at a side chain.

As a result of GPC measurement of the molecular weight of the resultant compound (1'), the weight-average molecular weight (Mw) was 12,000, and the number-average molecular weight (Mn) was 2,740.

In addition, the silicone chain ratio in the compound (1') determined from the raw material charge ratio was 30% by mass.

### (COMPARATIVE EXAMPLE 2: synthesis of polymer having silicone chain at side chain)

A compound (2') was produced by the same synthesis method as in Comparative Example 1 except that 160.0 g of polypropylene glycol-polybutylene glycol monomethacrylate and 40.0 g of a compound represented by the formula (A1-2) were used.

As a result of GPC measurement of the molecular weight of the resultant compound (2'), the weight-average molecular weight (Mw) was 11,700, and the number-average molecular weight (Mn) was 1,830.

In addition, the silicone chain ratio in the compound (2') determined from the raw material charge ratio was 19% by mass.

The compound (1) produced in Example 1 was used for evaluation described below.

### (Film formation and evaluation of coating film)

A resist composition was prepared by mixing 3.0 g of alkali-soluble resin 40 mass% resin solution (Acrydic ZL-295, manufactured by DIC Corporation), 1.2 g of Aronix M-402 (manufactured by Toagosei Chemical Co., Ltd., mixture of dipentaerythritol pentaacrylate and dipentaerythritol hexaacrylate), 0.0024 g in terms of solid content of the compound (1), and 6.23 g of propylene glycol monomethyl ether acetate (PGMEA).
Three ml of the resultant resist composition was dropped on a central portion of a chromium-plated glass substrate of 10 cm × 10 cm, spin-coated under the conditions including a rotational speed of 400 rpm and a rotation time of 20 seconds, and then dried by heating at 100°C for 100 seconds, forming a laminate having a coating film layer.

The smoothness and coating film defect of the coating film layer of the laminate formed were evaluated by methods below. The results are shown in Table 1.

### (Smoothness)

The smoothness of the coating film layer of the resultant laminate was evaluated by visual observation of the coating film layer according to criteria below.
A: No unevenness is observed in the coating film.
B: Substantially no unevenness is observed in the coating film.
C: Unevenness is observed over the entire region of the coating film.

### (Coating film defect)

The coating film defect of the coating film layer of the resultant laminate was evaluated by visual observation of the coating film layer according to criteria below.
A: Substantially no defect is observed in the coating film.
B: A few defects are observed in the coating film.
C: Many defects are observed in the coating film.

Evaluation was performed by the same method as for the compound (1) except that the compound produced in each of Examples 2 to 4 and Comparative Examples 1 and 2 was used in place of the compound (1). The results are shown in Table 1.

**[Table 1]**

| | Example 1 | Example 2 | Example 3 | Example 4 | Comparative Example 1 | Comparative Example 2 |
|---|---|---|---|---|---|---|
| Leveling agent | Compound (1) | Compound (2) | Compound (3) | Compound (4) | Compound (1') | Compound (2') |
| Coating film smoothness | A | A | A | A | A | A |
| Coating film defect | A | A | A | A | C | C |

Table 1 indicates that when a compound (the compounds (1) to (4)) having a polymer block at either ed of a silicone chain is used as a leveling agent, excellent smoothness can be obtained, and at the same time, substantially no coating film defect occurs. On the other hand, a compound (the compounds (1') and (2')) having a silicone chain at a side chain causes many defects in the coating film in spite of having substantially the same silicone chain ratio as the compound having a polymer block at both ends of a silicone chain.

## Claims

1. A compound comprising a polymer block of a polymerizable monomer at both ends of a silicone chain.

2. The compound according to Claim 1, wherein the silicone chain is a silicone chain represented by general formula (1) below, 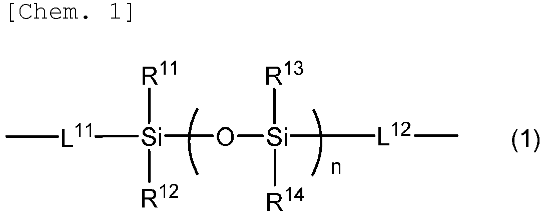 (In the formula (1),
R¹¹, R¹², R¹³, and R¹⁴ are each independently an alkyl group having 1 to 18 carbon atoms or a phenyl group;
L¹¹ and L¹² are each independently a divalent organic group or a single bond; and
n is an integer).

3. The compound according to Claim 1 or 2, wherein the polymerizable monomer is a polymerizable monomer having one or more selected from an alkyl group having 1 to 18 carbon atoms, an aromatic group having 6 to 18 carbon atoms, a group containing a polyoxyalkylene chain, and a group having a polyester chain.

4. The compound according to any one of Claims 1 to 3, wherein the polymerizable monomer is at least one or more selected from the group consisting of a compound represented by general formula (2-1) below, a compound represented by general formula (2-2) below, and a compound represented by general formula (2-3) below, 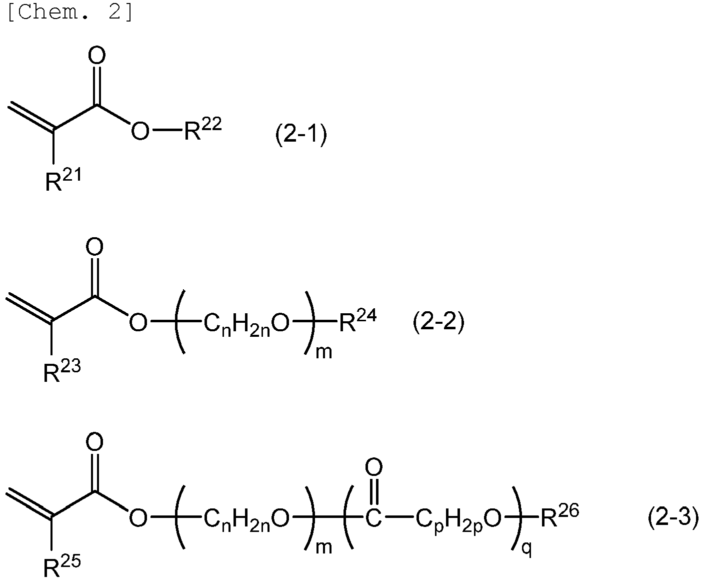 (In the formulae (2-1), (2-2), and (2-3),
R²¹ is a hydrogen atom or a methyl group,
R²² is an alkyl group having 1 to 18 carbon atoms,
R²³ is a hydrogen atom or a methyl group,
R²⁴ is a hydrogen atom or an alkyl group having 1 to 18 carbon atoms,
R²⁵ is a hydrogen atom or a methyl group,
R²⁶ is a hydrogen atom or an alkyl group having 1 to 18 carbon atoms,
n is an integer within a range of 1 to 4, m is an integer within a range of 1 to 200, p is an integer within a range of 1 to 10, and q is an integer within a range of 1 to 100) .

5. The compound according to any one of Claims 1 to 4, wherein the number-average molecular weight of the silicone chain is within a range of 500 to 10,000.

6. The compound according to any one of Claims 1 to 5, wherein the ratio of the silicone chain in the whole of the compound is within a range of 5% to 70% by mass.

7. A leveling agent comprising the compound according to any one of Claims 1 to 6.

8. A coating composition comprising the compound according to any one of Claims 1 to 6.

9. A resist composition comprising the compound according to any one of Claims 1 to 6.

10. An article comprising the compound according to any one of Claims 1 to 6.
